## Europäisches Patentamt

## European Patent Office

## Office européen des brevets

(11) Publication number: **0 072 443**
**B1**

(12) **EUROPEAN PATENT SPECIFICATION**

(45) Date of publication of patent specification: **04.06.86**

(51) Int. Cl.⁴: **G 03 B 41/00, G 01 J 1/42**

(21) Application number: **82106429.2**

(22) Date of filing: **16.07.82**

(54) Method and apparatus for measuring the illumination uniformity in a ring field projection system.

(30) Priority: **13.08.81 US 292466**

(43) Date of publication of application:
**23.02.83 Bulletin 83/08**

(45) Publication of the grant of the patent:
**04.06.86 Bulletin 86/23**

(84) Designated Contracting States:
**CH DE FR GB LI NL**

(56) References cited:
**EP-A-0 064 162**
**US-A-3 928 094**
**US-A-3 963 353**
**US-A-4 068 947**

**IBM TECHNICAL DISCLOSURE BULLETIN, vol.
23, no. 4, September 1980, pages 1414, 1415,
New York (USA ; W.B. Balder et al.:
"Adjustable lamp control slit".**

(73) Proprietor: **THE PERKIN-ELMER CORPORATION
Main Avenue
Norwalk Connecticut 06856 (US)**

(72) Inventor: **Liu, Raymond C.
27 Saint Mary's Lane
Norwalk Connecticut 06851 (US)**
Inventor: **Markle, David A.
18 Weatherbell Drive
Norwalk Connecticut 06851 (US)**

(74) Representative: **Patentanwälte Grünecker, Dr.
Kinkeldey, Dr. Stockmair, Dr. Schumann, Jakob,
Dr. Bezold, Meister, Hilgers, Dr. Meyer-Plath
Maximilianstrasse 58
D-8000 München 22 (DE)**

Courier Press, Leamington Spa, England.

**Description**

The invention relates to a method for correcting for variations of light intensity along a tapered arcuate slit employed in a scanning projection mask aligner, the steps comprising: providing a compliant member having an adjustable slit, detecting the intensity of light at positions along the length of said slit, obtaining a signal representative of the intensity of the light along the length of the slit. The invention also relates to an apparatus for measuring the illumination uniformity in a ring field projection system comprising a slit through which an object is to be illuminated from a light source, means for adjusting said slit, detector means disposed in said slit adapted to be moved along the length of said slit and comprising light sensor means providing a signal representative of the light intensity at the position of the detector means.

This type of apparatus finds particular use in the manufacture of integrated circuits. In one method of manufacturing such integrated circuits, an oxidized wafer of silicon is coated with a photo-resist material. The wafer may be of such dimensions that, after processing, it can be cut along rows and columns into a large number of chips. When such coated wafers are exposed to light, the photo-resist material polymerizes into a tenacious coating, whereas the unexposed portions of the layer are readily removable, as for example, by means of a solvent or developer. By means of a "mask" or "master", which is opaque except for a pattern of transparent lines and areas therein through which light can pass, the wafer with photo-resist coating is exposed to light in a pattern conforming to elements of a circuit to produce a photographic reverse thereof. The mask typically bears a multiplicity of the same pattern arranged in rows and columns. An image of the mask may be projected by image forming means onto the surface of the wafer as in projection printing.

In the EP—A—82 102 835, which has an earlier filing data but has not been prepublished, an apparatus of the above-mentioned type has already been described in which slit means are provided including compliant members and means for adjusting the width of the slit along the slit. The apparatus also includes detector means which may either be moved along the slit or may be installed along the slit in order to detect the light intensity passing through the slit at different positions along the slit. According to the signals received from the light detecting means, the means for altering the width of the slit may be controlled in order to realise a relatively uniform illumination along the slit.

An apparatus for such projection printing is also shown and described in US—A—4,068,947. In this patent, an optical apparatus is shown and described wherein a wafer may be exposed to the image of a mask through use of a pivotal carriage. In such an apparatus, it is important to regulate the light intensity uniformity because the fidelity of geometries produced in the photoresist depend on it. The slit through which the light passes must be properly tapered in accordance with the relative distance from the pivot axis of the carriage and different positions along the slit. As a result of this taper a light detector scanned along the slit would ideally see a linear variation of intensity as it transversed from one end of the slit to the other. It is practically impossible to adjust the slit under these conditions such that a uniform illumination of the mask or the object will be obtained.

The present invention now provides a method enabling the remedy of the deficiencies as stated above by providing a taper correction function based upon the position along the slit, multiplying said intensity trace signal by said correction factor to produce a signal that is constant along the slit and adjusting the width of the slit to provide uniform exposure in the slit direction.

According to a preferred embodiment the method is carried through such that the intensity of the lamp is monitored in order to obtain a measure of temporal variation in the intensity of light emitted thereby and the uniformity signal is divided by the lamp output signal.

Furthermore, in accordance with the invention, an apparatus as mentioned above is provided which is characterized in that the slit is a tapered slit, the detector means include a position detecting means providing a signal representative of the position of the said detector means along said tapered slit, a taper correction means to which the signal is applied from the position detecting means, a multiplier connected with the taper correction means and the light sensor means and a display means connected to said multiplier means providing a direct indication of light intensity deviation from ideal.

The inventive apparatus enables that in the special case of a ring field system and pivoting scanning system combination the linear variation in intensity produced by a tapered slit in the illumination system can be removed from the uniformity measurement so that only departures from the ideal are indicated.

A preferred embodiment of the invention is characterized in a monitoring means providing a signal representative of the intensity of said light source, and divider means connected to said monitoring means and between said multiplier means and said display means to correct for false variations in the display that would otherwise be caused by light source output fluctuations.

Preferably, variable amplification means are provided for varying the signal received from the light sensor.

Furthermore, it is advantageous in that reference voltage source is connected to said taper correction means.

Preferably, the position detecting means includes a potentiometer.

Preferably, the apparatus is used in a system for correcting for variations of light intensity from an ideal value of a lamp used to illuminate an arcuate slit imaged onto a mask that is supported on a pivoting carriage in a projection mask aligner.

The invention will be further explained in connection with the drawings wherein:

FIG. 1 is an isometric view of a carriage of an optical projection and scanning apparatus;

FIG. 2 is an enlarged, isometric view of the optical system shown within the carriage in Fig. 1;

FIG. 3 is a perspective view of the light source shown in Fig. 1;

FIG. 4 is elevational, cross sectional view of a slit adjusting device;

FIG. 5 is a plan view of an optical transducer that is used in the instant invention;

FIG. 6 is a block diagram of a uniformity variation indicator;

FIGS. 7a, 7b and 7c are diagrams showing various plots involved in the instant invention.

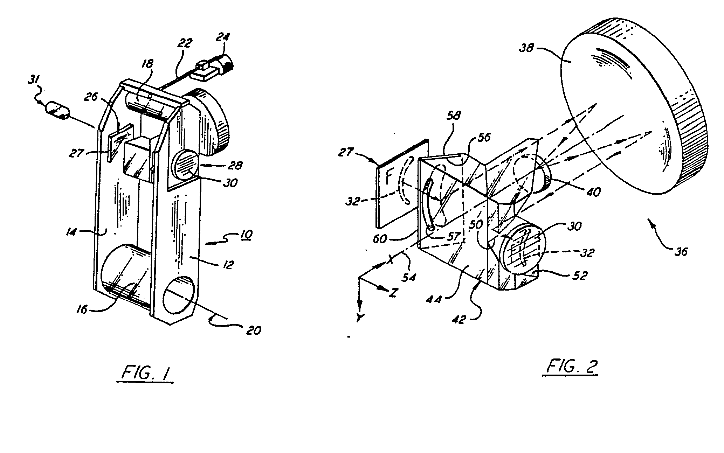

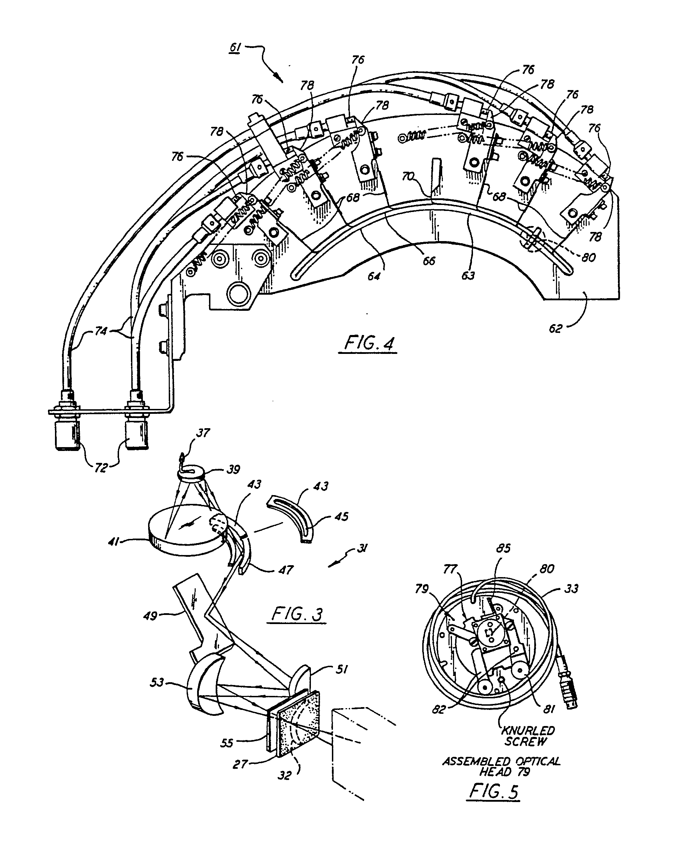

In Figs. 1 and 2 of the drawing, a portion of the optical projection and scanning apparatus shown and described in U.S. Patent 4,068,947 is shown. The instant invention is inherently involved with the apparatus shown and described in said U.S. Patent 4,068,947 and for a full understanding of the instant invention reviewing the disclosure in that patent is recommended. Referring now to Figs. 1 and 2, a carriage is shown generally at 10 and includes two parallel metallic side plates 12 and 14 held together by means of glass cylinders 16 and 18. The carriage 10 is mounted for arcuate rotation about the pivotal axis indicated at 20 which is located on or near the axis of the cylinder 16. The rotation is effected by means of the push rod 22 which connects to a drive mechanism 24. The side plate 14 includes a mask stage 26 supporting a mask 27 therein and the side plate 12 has a wafer stage 28 shown with a wafer 30 supported therein. The mask 27 is typically a glass plate with a partly opaque and partly transparent pattern laid down thereon. The mask stage 26 and wafer stage 28 are independently movable in finely controlled increments with respect to the carriage by means not shown. The wafers 30 are insertable into and removable from the wafer stage 28 by any convenient means. The masks 27 are similarly insertable into and removable from the mask stage 26. The mask 27 in the mask stage 26 is illuminated by a light source shown generally at 31, which is shown and described in detail in Fig. 3, that directs light through the mask 27.

The mask 27, when illuminated by light directed from the light source 31 will have an arcuate slit shaped image 32 projected therethrough and onto the surface of the wafer 30 at 32' through an optical system 36. The upper portion of the slit image 32 is caused to be wider than the lower portion because of the arcuate travel of the carriage 10. The components of the optical system 36 include a primary concave mirror 38, a secondary convex mirror 40 and a mirror array 42. The mirrors 38 and 40 are concentric or nearly so and the secondary mirror 40 is given a radius of curvature slightly greater than one-half the radius of the curvature of mirror 38, so as to achieve high quality imagery over an extra-axial zone which is caused to coincide with the illuminated slit-shaped image 32. The array 42 may be made from three blocks of glass 44, 46 and 48 suitably shaped and assembled. Details of this array 42 may be obtained by reference to the aforementioned U.S. Patent No. 4,068,947. Light from the mask 27 is reflected into the primary mirror 38 whence it is reflected to the secondary mirror 40, back to the primary mirror 38 and thence one more to the array 42.

Referring now to Fig. 3 the light source 31 that creates the slit image 32 on the mask 27 is shown in detail. The light source is an optical system which includes a mercury lamp 37 that addresses a secondary mirror 39 which is spaced to a primary mirror 41. Adjacent and slightly below the primary mirror 41 is a plate 43 having an arcuate slit 45 therein. Next to and below the plate 43 is a toroidal mirror 47. The balance of the optical system 31 includes a first flat mirror 49, a second flat mirror 51, a relay mirror 53, and an actinic filter 55 that addresses the mask 27. As can be seen by the arrows in Fig. 3, light from the mercury lamp 37 passes through the lens 39 and is directed to the primary mirror 41. The light is reflected from the primary mirror back to the opposite half of lens 39 which is coated so as to reflect the light to the plate 43. A portion of the light passes through the slit 45 onto the toroidal mirror 47 from where it is reflected to the first flat mirror 49, the second flat mirror 51, the relay mirror 53, and through the filter 55 to create the slit image 32 on the mask 27.

Referring now to Fig. 4, a compliant member is shown at 61 having a slit 63 therein and suitable components whereby the width of the slit may be adjusted along its entire arcuate length. This compliant member 61 consists of a plate 62 containing the semi-circular slit 63 of which one edge 64 is fixed to define one edge of the slit shape. A deformable band 66 is used to define the other edge of the slit 61 shape. This deformable band 66 is supported by six movable flexures 68 and one fixed flexure 70. By means of knobs 72 and flexible cables 74 an operator is able to turn adjustable screws 76 that are operative to displace pivoting levers 78 which in turn actuate the adjustable flexures 68 thus forming the band 66 to its desired configuration. By turning the knobs 72 an operator can form the band 66 in such a way as to permit a desired amount of light or energy per unit slit length, to pass through the slit 63, even if the lamp 37 supplying the light, or the intervening optics, is non-uniform or imperfectly aligned. This compliant member 61 may be placed at the location of the plate 43 for the purposes of matching the slit 45 required for the lamp 37 as is explained hereinafter.

In order to determine the energy per unit length passing through the slit 63 when the plate 43 is replaced by the compliant member 61, an optical head 77 is mounted on a ring 79 and consists of a detector 80 and a position sensing potentiometer 81 connected to a movable parallel linkage assembly 82, as shown in Fig. 5. The optical head 77 may be placed at the wafer stage 28 instead of at wafer 30. The shaft of the potentiometer 81 is mechanically attached to the movable linkage arm assembly 82 so that as the detector 80 is positioned, the potentiometer shaft rotates to provide a resistance value and a resulting voltage that corresponds to the angular position of the photo-detector 80 relative to the midpoint of the slit 63. A handle 85 is provided to selectively move the linkage arm assembly 82 so that the optical head 77 traverses along the slit 63 as indicated in Fig. 4. A lead 83 is provided to convey the signal generated by the detector 80.

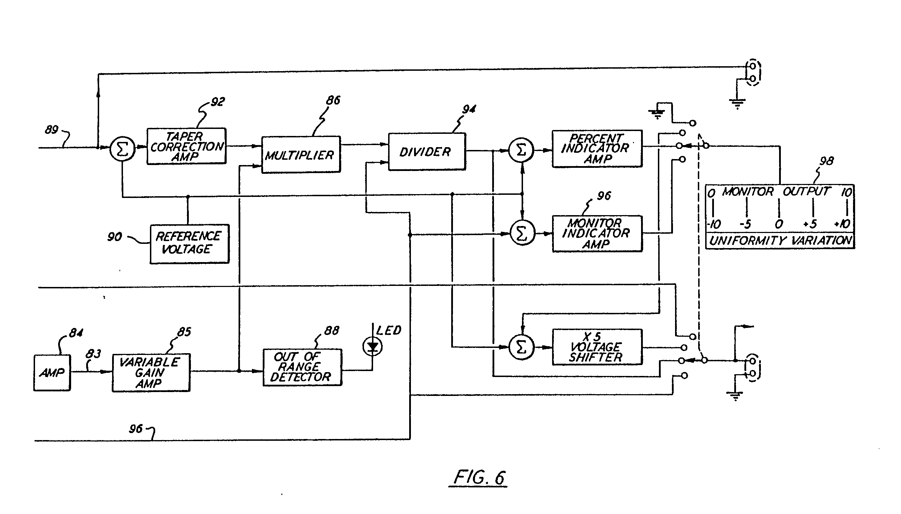

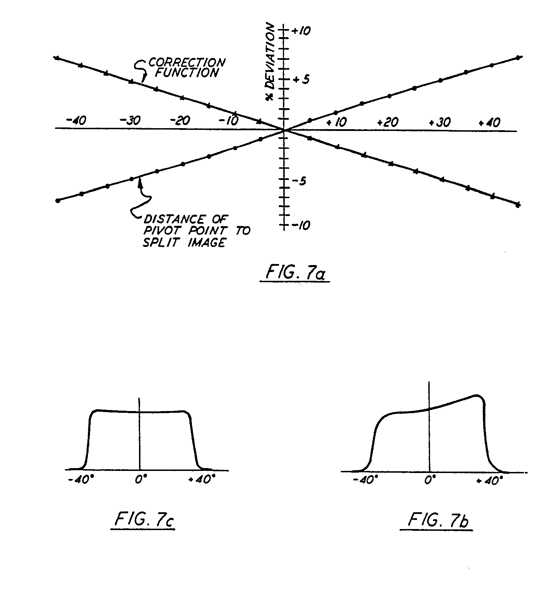

Referring now to Fig. 6 and 7 the lead 83 is connected to the output of the detector 80. This lead 83 is connected to a first amplifier 84 and then to a variable gain amplifier 85 which in turn is connected to one input terminal of a multiplier 86 and to an out of range detector 88. Another lead 89 is connected to the potentiometer 81 and, along with a reference voltage source 90, is connected to a taper correction amplifier 92 which in turn is connected to the other input of the multiplier 86. The output of the multiplier 86 is connected to one of two inputs of a divider 94, the other input being connected to a monitor intensity signal 96, the latter signal being indicative of the intensity of the light being measured.

The output of the variable gain amplifier 85, which of course is directly proportional to the output of the photo-detector 80, when plotted would give a trace shown Fig. 7b. The abscissa represents the position of the photo-detector 80 relative to the midpoint of the slit 63 and the ordinate represents the intensity of light received by the photo-detector 80. The trace exhibits a tilt of approximately 15% within the ±40 degree angle, the tilt resulting from the taper in the slit as seen by detector 80 looking through a narrow slit as it is scanned by the parallel linkage 82 along the slit image. In the carriage 10 shown in Fig. 1, the distance from the pivot axis 20 to the slit image 32 area is approximately 20 inches and the parallel linkage causes the optical head 77 to trace an arc of a 2.35 inch radius over a 90° arc. This combination occasions the 15° tilt at the top of the trace shown in Fig. 7b. Signals representative of this trace are supplied to one input of the multiplier 86 as seen in Fig. 6. The gain of the variable gain amplifier 84 is adjusted so that the output of the divider 94 is at a predetermined level at the center of the meter 98 when the detector is at the center of the slit. Assuming that the light passing through the slit 63 is uniform along the entire arcuate length of the slit, the required tapering of the light illumination is essentially a linear function. If the detector signals are multiplied by a complimentary function of opposite tilt at each detector position, as indicated in Fig. 7a, the result will be a horizontal trace. The taper correction amplifier 92 provides the signal of complimentary function. This signal is supplied to one terminal of the multiplier 86 and signals representative of the trace are supplied to the other terminal. These two inputs are multiplied and the output from the multiplier 86 assumes the configuration shown in Fig. 7c and is fed to one input of the divider 94. Since the output of the multiplier 86 will vary with change in lamp intensity, such as will occur with line voltage variation, the divider 94 is added for computing the ratio of the multiplier signal against the monitor intensity 96 signal to minimize output fluctuations. To indicate percent variation of uniformity, the output voltage of the divider 94 is adjusted manually by the variable gain amplifier and this voltage is then subtracted by the DC reference voltage supplied by the source 90 so that the indicator reading at the center of the meter becomes 0. With the system shown in Fig. 6 fully adjusted, one may then adjust the condenser system output using the compliant member 61 shown in Fig. 3. The width of the slit 63 of the compliant member 61 would be adjusted through the movable flexures 68 so that light illumination is uniform along the entire arcuate length of the slit. By being able to compensate for illumination non-uniformities, a considerable improvement in uniformity is realized.

By correcting for the tilt in the trace shown in Fig. 7b so that it assumes the trace shown in Fig. 7c, one is able to maintain a constant value on the meter 98 when adjusting the slit 63 of the compliant member. If such a constant value were not available, obvious difficulty and inaccuracy would be encountered in the control of the exposure of photoresist on the wafer.

## Claims

1. A method for correcting for variations of light intensity along a tapered arcuate slit employed in a scanning projection mask aligner, the steps comprising: providing a compliant member having an adjustable slit, detecting the intensity of light at positions along the length of said slit, obtaining a signal representative of the intensity of the light along the length of the slit, characterized in providing a taper correction function based upon the position along the slit, multiplying said intensity trace signal by said correction factor to produce a signal that is constant along the slit and adjusting the width of the slit to provide uniform exposure in the slit direction.

2. The method of claim 1, characterized in monitoring the intensity of the lamp to obtain a measure of temporal variation in the intensity of light emitted thereby and dividing the uniformity signal by the lamp intensity signal.

3. An apparatus for measuring the illumination uniformity in a ring field projection system comprising a slit (45) through which an object is to be illuminated from a light source (31), means (72, 76, 78) for adjusting said slit, detector means (77) disposed in said slit adapted to be moved along the length of said slit and comprising light sensor means (80) providing a signal (83) representative of the light intensity at the position of the detector means, characterized in that the slit is a tapered slit (45), the detector means include a position detecting means (81) providing a signal representative of the position of the said detector means along said tapered slit, a taper correction means (92) to which the signal is applied from the position detecting means (81), a multiplier (86) connected with the taper correction means (92) and the light sensor means (80) and a display means (98) connected to said multiplier means (86) providing a direct indication of light intensity deviation from ideal.

4. Apparatus according to claim 3, characterized in a monitoring means providing a signal (96) representative of the intensity of said light source (31), and divider means (94) connected to said monitoring means and between said multiplier means (86) and said display means (98) to correct for false variations in the display that would otherwise be caused by light source output fluctuations.

5. Apparatus according to claim 3 or 4, characterized in that variable amplification means (85) are provided for varying the signal (83) received from the light sensor (80).

6. Apparatus according to any one of claims 3 to 5, characterized in a reference voltage source (90) connected to said taper correction means (92).

7. Apparatus in accordance with any one of the claims 3 to 6, characterized in that the position detecting means comprises a potentiometer.

8. Apparatus according to any one of claims 3 to 7 used in a system for correcting for variations of light intensity from an ideal value of a lamp used to illuminate an arcuate slit (45) imaged on to a mask (27) that is supported on a pivoting carriage (10) in a projection mask aligner.

**Revendications**

1. Procédé pour la correction des variations d'intensité lumineuse sur la longueur d'une fente arquée allant s'amenuisant employée dans un dispositif de centrage de masque de projection à balayage, les opérations consistant à: prévoir un élément souple présentant une fente réglable, détecter l'intensité lumineuse en des emplacements sis sur la longueur de la fente, obtenir un signal représentatif de l'intensité lumineuse existant sur la longueur de la fente, caractérisé en ce que qu'on prévoit une fonction de correction d'amenuisement basée sur l'emplacement le long de la fente, en ce qu'on multiplie ledit signal de tracé d'intensité par ledit facteur de correction pour obtenir un signal qui soit constant le long de la fente et en ce qu'on ajuste la largeur de la fente pour assurer une exposition uniforme dans la direction de la fente.

2. Procédé selon la revendication 1, caractérisé en ce qu'on surveille l'intensité de la lampe pour obtenir une mesure de la variation temporelle de l'intensité de la lumière qu'elle émet et on divise le signal d'uniformité par le signal d'intensité de lampe.

3. Appareil pour la mesure de l'uniformité d'éclairement dans un système de projection à champ en anneau présentant une fente (45) à travers laquelle un objet doit être éclairé à partir d'une source lumineuse (31), des moyens (72, 76, 78) pour ajuster cette fente, des moyens détecteurs (77) disposés dans ladite fente qu'on peut déplacer le long de cette fente et comprenant des moyens de détection de lumière (80) fournissant un signal (83) représentatif de l'intensité lumineuse à l'emplacement des moyens détecteurs, caractérisé en ce que la fente est une fente qui va s'amenuisant (45), les moyens détecteurs comportent un moyen de détection d'emplacement (81) fournissant un signal représentatif de l'emplacement desdits moyens détecteurs le long de ladite fente allant s'amenuisant, un moyen correcteur d'amenuisement (92) auquel le signal est appliqué à partir du moyen de détection d'emplacement (81), un multiplicateur (86) relié au moyen correcteur d'amenuisement (92) et aux moyens détecteurs de lumière (80) et un moyen d'affichage (90) relié audit moyen multiplicateur (86) fournissant une indication directe de l'écart de l'intensité lumineuse par rapport à l'idéal.

4. Appareil selon la revendication 3, caractérisé en ce qu'un moyen de surveillance fournit un signal (96) représentatif de l'intensité de ladite source lumineuse (31), et des moyens diviseurs (94) reliés audit moyen de surveillance et monté entre ledit multiplicateur (86) et ledit moyen d'affichage (98) pour corriger de fausses variations de l'affichage qui seraient autrement provoquées par des fluctuations de l'énergie de sortie de la source lumineuse.

5. Appareil selon la revendication 3 ou 4, caractérisé en ce que des moyens d'amplification variables (85) sont prévus pour faire varier le signal (83) reçu du détecteur de lumière (80).

6. Appareil selon l'une quelconque des revendications 3 à 5, caractérisé en ce qu'une source de tension de référence (90) est reliée audit moyen de correction d'amenuisement (92).

7. Appareil selon l'une quelconque des revendications 3 à 6, caractérisé en ce que le moyen de détection d'emplacement comprend un potentiomètre.

8. Appareil selon l'une quelconque des revendications 3 à 7 utilisé dans un système pour la correction de variations par rapport à une valeur idéale de l'intensité lumineuse d'une lampe servant à éclairer une fente arquée (45) dont l'image figure sur un masque (27) supporté sur un chariot pivotant (10) dans un dispositif de centrage de masque.

**Patentansprüche**

1. Verfahren zum Korrigieren von Änderungen der Lichtintensität längs eines spitz zulaufenden, bogenförmigen Schlitzes, der in einem abtastenden Projektionsmaskenausrichter verwendet wird, enthaltend folgende Schritte: Bereitstellen eines nachgiebigen Bauteils mit einem einstellbaren Schlitz, Ermitteln der Lichtintensität an Positionen längs der Länge des Schlitzes, Erhalten eines die Intensität des Lichts längs der Länge des Schlitzes darstellenden Signals, gekennzeichnet durch Bereitstellen einer Verjüngungskorrekturfunktion auf der Grundlage der Position längs des Schlitzes, Multiplizieren des Intensitätsspursignals mit dem Korrekturfaktor zur Erzeugung eines Signals, das längs des Schlitzes konstant ist, und Einstellen der Breite des Schlitzes, um eine gleichmäßige Belichtung in Schlitzrichtung zu erzielen.

2. Verfahren nach Anspruch 1, gekennzeichnet durch Beobachten der Intensität der Lampe, um ein Maß der zeitlichen Variation in der Intensität des davon emittierten Lichtes zu erhalten, und Teilen des Verteilungssignals durch das Lampenintensitätssignal.

3. Vorrichtung für die Messung der Intensitätsverteilung in einem Ringfeldprojektionssystem mit einem Schlitz (45), durch den ein Objekt von einer Lichtquelle (31) zu beleuchten ist, einer Einrichtung (72, 76, 78) zum Einstellen des genannten Schlitzes, einer in dem Schlitz angeordneten Detektoreinrichtung (77), die längs der Länge des Schlitzes verschoben werden kann und eine Lichtsensoreinrichtung (80) enthält, die ein die Lichtintensität an der Stelle der Detektoreinrichtung darstellendes Signal (83) erzeugt, dadurch gekennzeichnet daß der Schlitz ein sich verjüngender Schlitz (45) ist, die Detektoreinrichtung eine Positionsermittlungseinrichtung (81) enthält, die ein Signal abgibt, das für die Position der Detektoreinrichtung längs des sich verjüngenden Schlitzes repräsentativ ist, eine Verjüngungskorrektureinrichtung (92), der das Signal von der Positionsermittlungseinrichtung (81) zugeführt wird, eine Multiplizierstufe (86), die mit der Verjüngungskorrektureinrichtung (92) und der Lichtsensoreinrichtung (80) verbunden ist, und eine Anzeigeeinrichtung (98), die mit der Multiplizierstufe (86) verbunden ist und eine direkte Anzeige der Lichtintensitätsabweichung von einem Idealwert liefert.

4. Vorrichtung nach Anspruch 3, gekennzeichnet durch eine Monitoreinrichtung, die ein Signal (96) liefert, das die Intensität der Lichtquelle (31) darstellt, und durch eine Teilereinrichtung (94), die mit der Monitoreinrichtung verbunden und zwischen das Multiplizierglied (86) und die Anzeigeeinrichtung (98) geschaltet ist, um falsche Änderungen in der Anzeige zu korrigieren, die ansonsten durch Lichtquellenausgangsschwankungen hervorgerufen würden.

5. Vorrichtung nach Anspruch 3 oder 4, dadurch gekennzeichnet, daß variable Verstärkungseinrichtungen (85) vorgesehen sind, um das Signal (83) zu verändern, das von dem Lichtsensor (80) empfangen wird.

6. Gerät nach einem der Ansprüche 3 bis 5, gekennzeichnet durch eine Bezugsspannungsquelle (90), die mit der Verjüngungskorrektureinrichtung (92) verbunden ist.

7. Vorrichtung nach einem der Ansprüche 3 bis 6, dadurch gekennzeichnet, daß die Positionsdetektoreinrichtung ein Potentiometer enthält.

8. Gerät nach einem der Ansprüche 3 bis 7, verwendet in einem System zum Korrigieren von Änderungen der Lichtintensität gegenüber einem Idealwert einer Lampe, die dazu verwendet wird, einen bogenförmigen Schlitz (45) zu beleuchten, der auf einer Maske (27) abgebildet wird, die von einem schwenkbaren Träger (10) in einem Projektionsmaskenausrichter getragen wird.

FIG. 1

FIG. 2

FIG. 4

FIG. 3

FIG. 5

KNURLED
SCREW

ASSEMBLED OPTICAL
HEAD 79

_FIG. 6_

FIG. 7a

FIG. 7c

FIG. 7b